Europäisches Patentamt

European Patent Office

Office européen des brevets

(11) Publication number: **0 221 184**
**B1**

## (12) EUROPEAN PATENT SPECIFICATION

(45) Date of publication of patent specification: **16.08.90**

(21) Application number: **85903053.8**

(22) Date of filing: **21.06.85**

(84) International application number:
**PCT/JP85/00349**

(87) International publication number:
**WO 86/00426 16.01.86 Gazette 86/02**

(51) Int. Cl.⁵: **G 03 F 1/00, H 01 L 21/30,**
**C 23 C 14/22**

(54) **MASK REPAIRING APPARATUS.**

(30) Priority: **26.06.84 JP 131720/84**
**05.11.84 JP 232853/84**
**13.11.84 JP 171789/84**

(43) Date of publication of application:
**13.05.87 Bulletin 87/20**

(45) Publication of the grant of the patent:
**16.08.90 Bulletin 90/33**

(84) Designated Contracting States:
**DE FR GB NL**

(56) References cited:
**JP-A-53 135 276**
**JP-A-55 111 132**
**US-A-3 930 155**

**JAPANESE JOURNAL OF APPLIED PHYSICS,
vol. 23, no. 5, May 1984, pages L293-L295, Tokio,
JP; K. GAMO et al.: "Ion beam assisted
deposition of metal organic films using focused
ion beams"**

(73) Proprietor: **SEIKO INSTRUMENTS INC.**
**31-1, Kameido 6-chome Koto-ku**
**Tokyo 136 (JP)**

(72) Inventor: **SATO, Mitsuyoshi**
**Seiko Instruments & Electronics Ltd.**
**31-1, Kameido 6-chome Koto-ku Tokyo 136 (JP)**
Inventor: **KAITO, Takashi**
**Seiko Instruments & Electronics Ltd.**
**31-1, Kameido 6-chome Koto-ku Tokyo 136 (JP)**
Inventor: **NAKAGAWA, Yoshitomo**
**Seiko Instruments & Electronics Ltd.**
**31-1, Kameido 6-chome Koto-ku Tokyo 136 (JP)**

(74) Representative: **Miller, Joseph et al**
**J. MILLER & CO. Lincoln House 296-302 High
Holborn**
**London WC1V 7JH (GB)**

(56) References cited:
**PATENT ABSTRACTS OF JAPAN, vol. 5, no. 23
(E-45)695r, 12th February 1981; & JP-A-55 150
226**

**PATENT ABSTRACTS OF JAPAN, vol. 9, no. 181
(E-331)1904r, 26th July 1985; & JP-A-60 52 022**

## Description

The present invention relates to a mask-repairing device e.g. for use in the repair of excessive or inadequate film formation on a mask employed in semiconductor manufacturing, or to repair disconnections in wiring and short circuits.

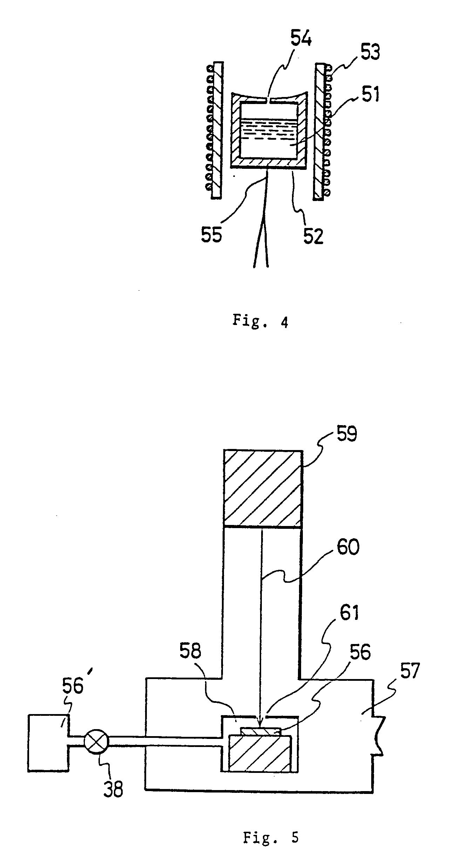

It is known to repair semiconductors and masks by patterning a film at a target position, this being effected by discharging an ion beam onto a predetermined position on the sample in an atmosphere containing a compound vapour. One way of supplying the compound vapour to the target position on the sample is the Knudsen cell method described in "New Course 2 of Experimental Chemistry" published by Maruzen, pages 371 to 379. As shown in Figure 4, a Knudsen cell 52 in which a compound 51 is stored, is heated by a heater 53 provided on its outer circumferential surface, and the compound evaporated by the heating is ejected through an orifice 54. However, a thermocouple 55 is provided on the Knudsen cell 52 so that it is possible to control the heating temperature and to control the amount of the compound vapour ejected. A similar method has also been proposed to form a pattern film utilizing the reaction between a charged particle beam and a chemical compound, this method having been proposed in the draft manuscript of a lecture on "The Injection of Ions and the Processing of Submicrons" of the 15th Symposium held in the Physico Chemical Research Institute. In this case, as illustrated in Figure 5, the compound vapour from a chamber 56' is supplied to a sub-sample chamber 58 provided within a sample chamber 57, and then an electron beam 60 is discharged from an electron gun 59 so as to be applied to a sample 56, the beam 60 passing through a small bore 61 provided in the sub-sample chamber 58.

In the arrangement shown in Figure 4, the compound vapour which is ejected from the orifice 54 spreads over a broad area without any directional characteristics. The region to which a charged particle beam should be applied so as to form the pattern film is, however, smaller than 1 × 1 mm. Therefore, the compound vapour directed to anywhere beyond the target position is wasted, and causes various disadvantages. For example, when the compound vapour is directed onto unnecessary areas, the amount of compound vapour supplied to the area where the pattern film is to be formed may change as time passes, or, when a charged particle beam such as an ion beam is utilized, it may cause problems such as a reduction in the life span of the ion source as the compound becomes attached to the charged particle beam apparatus.

Also, in the apparatus illustrated in Figure 5, as it involves the use of the sub-sample chamber 58 inside the sample chamber 57, not only does a complicated apparatus (not shown) need to be provided to move the sample 56, but also the detection of the defects of the mask becomes difficult. Furthermore, the following three mechanisms are required in the case of a mask-repairing device that utilizes an ion beam; an insufficiently formed film defect repairing mechanism which allows a thin film to be formed by the reaction between the compound vapour and the ion beam; an excess film defect repairing mechanism which removes unnecessary thin film by ion beam sputtering; and a sample surface detecting mechanism which utilizes secondary charged particles. Therefore, at the time of repairing an insufficiently formed film, the compound vapour must be guided into the sub-sample chamber, but at the time of repairing an excess film defect, it is necessary to conduct effective sputtering, so that the partial pressure of the vapour inside the sub-sample chamber must be sufficiently low. Consequently, a mask-repairing device utilizing a sub-sample chamber cannot be operated quickly as it takes too much time in controlling the ON-OFF condition of the compound vapour.

An object of the present invention is therefore to provide a mask-repairing device that easily controls ON-OFF operation of the ejection of the compound vapour and applies the vapour directionally, without polluting unnecessary areas.

Also, another object of the present invention is to provide a mask-repairing device that can form a thin film not only on a flat portion of the sample but also on a recessed portion which is adjacent to the pattern, under the same conditions.

Furthermore, the invention has the object of providing a mask-repairing device that reduces the amount of the compound vapour which is ejected so as to prevent the inside of a sample chamber from being polluted, and so as to prolong the life span of the ion source.

In Japanese Journal of Applied Physics, Volume 23, No. 5, May 1984, pages L 293 — L 295 there is disclosed a mask-repairing device in which a compound vapour outlet member is disposed within a vacuum vessel for the supply of compound vapour to the interior of a sample chamber disposed within the vacuum vessel. The sample chamber in this arrangement, however, is filled with compound vapour whose supply to the sample chamber is not controlled in any way and is not directed onto the sample, so that the disadvantages referred to above are not avoided.

In US-A-3,930,155 there is disclosed an ion microprobe analyser which employs a compound vapour outlet member constituted by a nozzle the flow through which is controlled by a valve, the nozzle being disposed within a vacuum vessel. However, there is no suggestion that this construction should be used in a mask-repairing device. Moreover, the nozzle is well spaced from the valve and neither the valve nor a compound vessel for supplying the vapour to the nozzle is disposed within the vacuum vessel. If the construction shown in US-A-3,930,155 were used in a mask-repairing device, the spacing of the nozzle from the valve would make it difficult to use the compound vapour economically and to control the flow of the compound vapour rapidly.

According, therefore, to the present invention,

there is provided a mask-repairing device comprising a compound vessel having a space therein to store compound; and a compound vapour outlet member which is disposed within a vacuum vessel and which is adapted to communicate with said space characterised in that the outlet member is constituted by a nozzle which is disposed immediately adjacent to said space and which communicates with the latter by way of a valve so that in operation, when the valve is open, compound vapour passes from said space and is ejected from the nozzle in the form of a jet.

Preferably, the compound vessel is mounted within the vacuum vessel.

The nozzle may communicate with a space by way of a tube which is surrounded by said space, the valve comprising a valve seat on an end surface of said tube and a closure member which is movable onto and away from the valve seat.

Heating means may be provided for heating compound in said space. The heating means may be electrical heating means mounted on the exterior of the compound vessel.

Preferably, there are movement-effecting means for moving the nozzle with respect to a sample support, and limit means for limiting movement of the nozzle towards the sample support.

The arrangement is preferably such that the valve is open only when the nozzle is in a predetermined position with respect to the sample support.

Means are preferably provided for moving the sample support with respect to the nozzle, said means being operative only when the valve is closed.

Preferably, the mask-repairing device is such that it can form thin film onto a flat portion of a sample and also onto a recessed portion adjacent to the pattern.

Several compound vapour ejecting nozzles may if desired be disposed around a fixed ion beam emitting position.

The invention is illustrated, merely by way of example, in the accompanying drawings, in which:—

Figure 1 is a sectional view of a first embodiment of a mask-repairing device according to the present invention;

Figure 2 is a general sectional diagram of a second embodiment of the present invention in which for convenience of illustration a valve is shown as spaced from a nozzle thereof;

Figure 3 is a sectional diagram of a part of the structure of Figure 2;

Figure 4 is a sectional diagram showing the main part of a known compound vapor ejection device (Knudsen) cell; and

Figure 5 is a general sectional diagram showing a known thin film forming device.

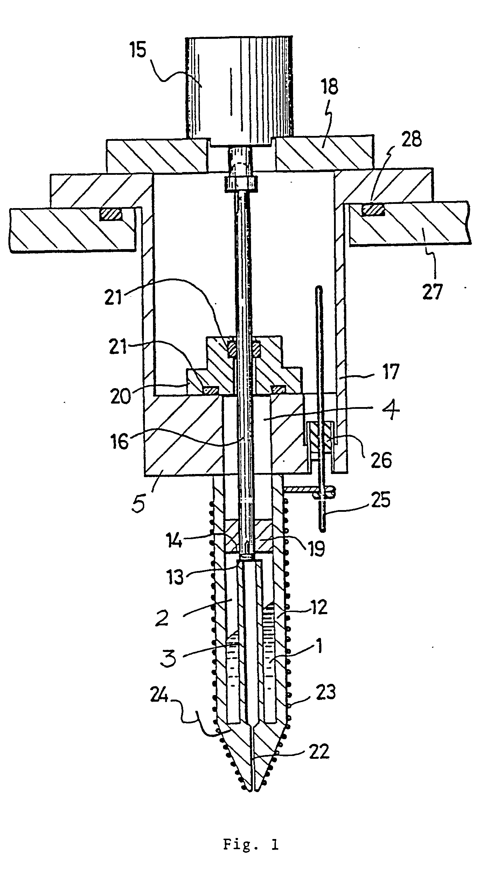

In Figure 1 there is shown a first embodiment of a mask-repairing device according to the present invention comprising a vessel 12 (hereinafter referred to as a "compound vessel") which is adapted to store compound 1 within a space 2 in the compound vessel 12. The space 2 communicates with a nozzle 22 when a valve 13, 14 is open, the valve 13, 14 comprising a valve seat 13 and a plunger 14. The valve seat 13 is constituted by an end surface of a compound vapour guide tube 3 which is mounted concentrically in the compound vessel 12 and which communicates with the nozzle 22. As will be clear from Figure 1, when the plunger 14 is seated on the valve seat 13, the valve is in its closed condition, and when the plunger 14 moves axially away from the valve seat 13, the valve is in its open condition. The movement of the plunger 14 is effected by a cylinder 15 through a rod 16. The rod 16 is mounted within a housing 17 and passes through a space 4 in the base 5 of the housing 17. The housing 17 abuts the upper end of the compound vessel 12. The cylinder 15 is mounted on and retained by a cylinder mounting board 18 which closes the upper end of the housing 17. A valve bearing 19, which is mounted within the compound vessel 12, guides the movement of the rod 16. When the valve 13, 14 is in its closed condition, the compound 1 is enclosed within the space 2 in the compound vessel 12. Sealing material 20 and O rings 21 close the upper end of the space 4 so as to permit the nozzle 22 side to be subjected to vacuum, while the cylinder 15 side is subjected to atmospheric pressure. The nozzle 22 is a tubelike nozzle which is provided to eject the vapour of the compound 1 in the form of a jet. A heater line 23 covers the whole of the compound vessel 12 to uniformly heat the compound 1. A thermocouple 24 detects the temperature of the compound vessel 12. A feed-through 25 takes the terminal of the heater line 23 and the thermocouple 24 outside a vacuum vessel 27 within which the housing 17 and compound vessel 12 are mounted, the vacuum vessel 27 being sealed to the housing 17 by an O ring 28. The feed-through 25 connects to a temperature controller (not shown). An insulator 26 insulates the feed-through 25 from the housing 17. As a result of the provision of the vacuum vessel 27 and the O ring 28, the nozzle 22 side of Figure 1 becomes the inner part of the vacuum vessel.

In the embodiment of Figure 1, the pressure within the vacuum vessel 27 is less than $1 \times 10^{-5}$ Torr ($1.33 \times 10^{-3}$ Pa) and the compound 1 is phenanthrene. Also, for example, when the compound vessel 12 is heated to 80°C, the pressure within the compound vessel 12 becomes approximately 0.16 Torr (21.3 Pa) because of phenanthrene vapor. When the valve 13, 14 is opened at this point, the phenanthrene vapour is ejected through the nozzle 22 in the form of a thin jet. The width of the jet and the amount of vapour ejected are determined by the diameter and the length of the nozzle, as stated in J. Appl. Phys. 41 (1970) 2769 2776 of Olander and Kruger.

As stated above, when the compound vapour ejection device of Figure 1 is utilized, compound vapour with a low vapour pressure is ejected only in a limited area, and thus an unnecessarily large area is not polluted. Moreover, it is convenient to be able to control the amount of the compound vapor ejected easily. Furthermore, the ion source is no longer polluted, and a mask-repairing device can be provided with an ion source having a longer life span.

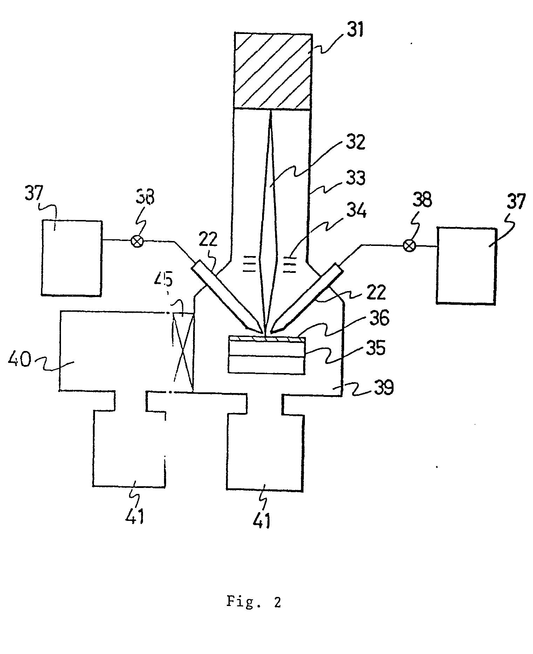

In Figure 2 there is shown a second embodiment of a mask-repairing device according to the present invention in which an ion beam 32 from an ion source 31 is directed onto the surface of a sample 36 which is mounted on a sample stage 35. The ion beam 32 is directed onto the sample 36 by way of an object glass 34 mounted within an ion beam ejection housing 33. The positions of defects detected in advance by a defect detecting device are moved to the target position by driving the sample stage 35. The form and the position of the defects can be examined by examining the surface of the mask by scanning the ion beam 32 by means of an examination device (not shown). The form of the defect is inputted into an ion beam control device, and the defect of the mask is repaired by scanning the ion beam. When the defect is constituted by an insufficiently formed film, it is repaired by forming a thin film by the reaction between the compound vapour and the ion beam. This is done after the compound vapor from a compound vapor supply device 37, which is composed of the compound vessel 12 and the heat line 23 (not shown), has been directed through a valve 38 and the nozzle 22 to the ion beam target position. However, a plurality of nozzles 22 are provided around the ion beam target position, or are mounted opposite to the ion beam target position. By using several nozzles 22, it is possible to spray compound vapour simultaneously from all of them onto the ion beam target position.

Also, when the defect is constituted by the formation of excess film, this is repaired by effecting sputtering by means of the ion beam while cutting off the supply of the compound vapor by closing the valve 38.

In the embodiment of Figure 2, as the vapor is directed to a predetermined position by several nozzles, not only the unpatterned portion of the mask, but also undulating portions of the pattern are not hidden from other nozzles. Consequently, it is possible to form a thin film with only a small amount of the compound vapor being ejected. Therefore, the amount of pollution inside the sample chamber is reduced, and the life span of the ion source is prolonged.

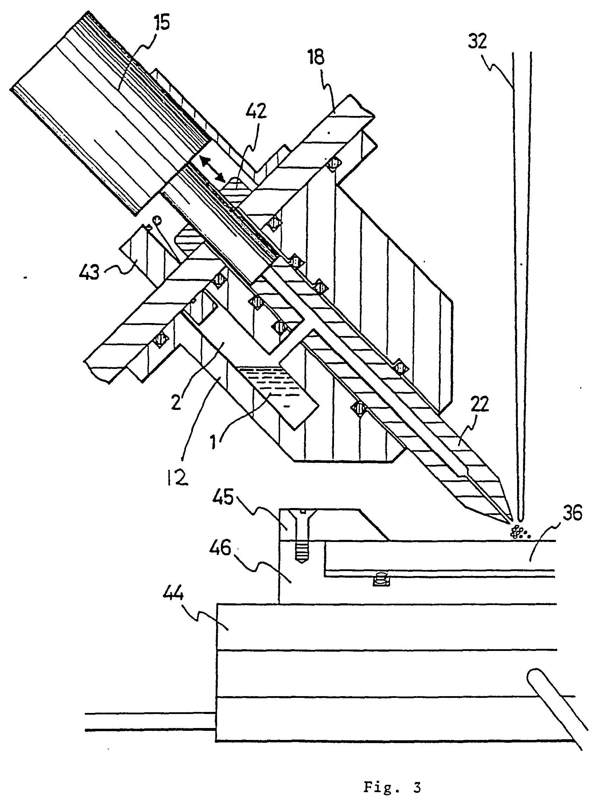

Although Figure 2, for ease of illustration, shows the valve 38 as spaced from the nozzle 22, the construction is in fact as shown in the sectional view of Figure 3.

As shown in Figure 2, the sample chamber 39 and sub-chamber 41 are evacuated by vacuum pumps 41. The sample 36 can be introduced and withdrawn by the opening and closing of a gate valve 45.

At this point, as the compound vapor ejection device emits compound vapor in the form of a jet from a thin nozzle, the absolute amount of the compound vapor can be reduced. Figure 3 shows an example of the compound vapor ejection device. The nozzle 22 supplies compound vapor to the defect position on sample 36. The compound vessel 12 heats the compound 1 stored therein, and its vapour is led to the nozzle 22. A stopper 42 is provided onto the nozzle. The tip of the nozzle 22 is connected to the cylinder 15. By driving the cylinder 15, the tip of nozzle 22 of the compound vapor ejection device moves backwards and forwards. When the tip of the nozzle 22 moves forwards, a stopper 42 hits the mounting plate 18, and the nozzle cannot move forwards any more. The distance between the end of the nozzle 22 and the sample 36 at this point, is fixed at its best distance, and repair of the mask defects is possible with only a small amount of compound vapor.

When the nozzle moves backwards, after it has moved a predetermined amount, the communication between the interior of the compound vessel 12 and the nozzle 22 is cut off, and the ejection of compound vapor is interrupted. At the same time, the stopper 42 starts operating a micro switch 43.

As a result of the signal from this micro switch 43 the sample base 44, which has been locked up to this point, can be driven. Also, it becomes possible to open and close a gate valve 45 between the sample chamber 39 and the sub-sample chamber 40.

Therefore, the introduction and withdrawal of the sample 36 can be done only when the end of the nozzle 22 has moved backwards. Thus accidents can be prevented, whereas in the past the nozzle 22 etc. was damaged by contact between the end of the nozzle 22 and the gate valve 45. Also, the construction of the present embodiment which allows the tip of the nozzle 22 to be brought very close to the sample 36, enables the amount of the compound vapor which is ejected to be reduced to a minimum. Consequently, the load on the vacuum exhaust system can be reduced. Also the pollution within the sample chamber 39 is reduced and the life span of the ion source is prolonged. In the Figure 3 construction, the compound vessel 12 is provided inside the sample chamber 39, but in order to replace the compound easily, the compound vessel 12 can be provided on the outside of the sample chamber 39 as in Figure 2, and can supply the vapor with the same result as indicated above.

As indicated above, the embodiments shown in the drawings are of value in repairing an insufficiently formed film and in correcting for an excess of film in semiconductor manufacturing. The amount of compound vapour ejected and its ON-OFF conditions can easily be controlled, the amount ejected can be reduced, the operation of repairing a mask defect is improved, and pollution inside the sample chamber is reduced, and thus a mask-repairing device with a long life span ion source can be obtained. Also as contact between the end of the nozzle and the sample (mask) etc. is prevented, the reliability of the device itself is improved.

Also, as it is possible both to conduct an examination into the positions of defects in the mask and to repair inadequate and surplus film defects with one device, the repair of the mask can be done accurately and speedily. However, the mask-repairing device of the present invention can be utilized not only for repairing photomasks and X-ray masks, but can also be utilized for connecting and cutting the wiring of a super LSI.

## Claims

1. A mask-repairing device comprising a compound vessel (12) having a space (2) therein to store compound (1); and a compound vapor outlet member (22) which is disposed within a vacuum vessel (27) and which is adapted to communicate with said space (2) characterised in that the outlet member is constituted by a nozzle (22) which is disposed immediately adjacent to said space (2) and which communicates with the latter by way of a valve (13, 14) so that in operation, when the valve (13, 14) is open, compound vapor passes from said space (2) and is ejected from the nozzle (22) in the form of a jet.

2. A mask-repairing device as claimed in claim 1 characterised in that the compound vessel (12) is mounted within the vacuum vessel (27).

3. A mask-repairing device as claimed in claim 1 or 2 characterised in that the nozzle (22) communicates with the space (2) by way of a tube (3) which is surrounded by said space (2), the valve (13, 14) comprising a valve seat (13) on an end surface of said tube (3) and a closure member (14) which is movable onto and away from the valve seat (13).

4. A mask-repairing device as claimed in any preceding claim characterised by heating means (23) for heating compound (1) in said space (2).

5. A mask-repairing device as claimed in claim 4 characterised in that the heating means (23) are mounted on the exterior of the compound vessel (12).

6. A mask-repairing device as claimed in any preceding claim characterised in that there are movement effecting means (15) for moving the nozzle (22) with respect to a sample support (44), and limit means (18, 42) for limiting movement of the nozzle (22) towards the sample support (44).

7. A mask-repairing device as claimed in claim 6 characterised in that the valve (13, 14) is open only when the nozzle (22) is in a predetermined position with respect to the sample support (44).

8. A mask-repairing device as claimed in claim 6 or 7 characterised in that means are provided for moving the sample support (44) with respect to the nozzle (22), said means being operative only when the valve (13, 14) is closed.

## Patentansprüche

1. Maskenrepariervorrichtung mit einem Verbindungsgefäß (12), das einen Raum (2) zur Aufnahme einer Verbindung (1) aufweist, und mit einem Verbindungsdampf-Auslaßelement (22), das in einem Vakuumgefäß (27) angeordnet ist und mit dem Raum (2) in Verbindung steht, dadurch gekennzeichnet, daß das Auslaßelement durch eine Düse (22) gebildet ist, welche unmittelbar benachbart zum Raum (2) angeordnet ist und welche mit diesem über ein Ventil (13, 14) in Verbindung steht, so daß bei offenem Ventil (13, 14) Verbindungsdampf aus dem Raum (2) austritt und aus der Düse (22) in Form eines Strahls ausgestoßen wird.

2. Maskenrepariervorrichtung nach Anspruch 1, dadurch gekennzeichnet, daß das Verbindungsgefäß (12) im Vakuumgefäß (27) montiert ist.

3. Maskenrepariervorrichtung nach Anspruch 1 oder 2, dadurch gekennzeichnet, daß die Düse (22) mit dem Raum (2) über ein Rohr (3) in Verbindung steht, das vom Raum (2) umgeben ist, und daß das Ventil (13, 14) einen Ventilsitz (13) auf einer Endfläche des Rohrs (3) und ein auf den Ventilsitz (13) hin und von diesem weg bewegbares Verschlußelement (14) umfaßt.

4. Maskenrepariervorrichtung nach den vorhergehenden Ansprüchen, gekennzeichnet durch eine Heizeinrichtung (23) zum Erwärmen der Verbindung (1) im Raum (2).

5. Maskenrepariervorrichtung nach Anspruch 4, dadurch gekennzeichnet, daß die Heizeinrichtung (23) auf der Außenseite des Verbindungsgefäßes (12) montiert ist.

6. Maskenrepariervorrichtung nach den vorhergehenden Ansprüchen, dadurch gekennzeichnet, daß eine eine Bewegung hervorrufende Einrichtung (15) zur Bewegung der Düse (22) in Bezug auf eine Probenhalterung (44) und eine Begrenzungseinrichtung (18, 42) zur Begrenzung der Bewegung der Düse (22) zur Probenhalterung (44) hin vorgesehen sind.

7. Maskenrepariervorrichtung nach Anspruch 6, dadurch gekennzeichnet, daß das Ventil (13, 14) lediglich offen ist, wenn sich die Düse (22) in einer vorgegebenen Stellung in Bezug auf die Probenhalterung (44) befindet.

8. Maskenrepariervorrichtung nach Anspruch 6 oder 7, dadurch gekennzeichnet, daß eine Einrichtung zur Bewegung der Probenhalterung (44) in Bezug auf die Düse (22) vorgesehen ist, die lediglich wirksam ist, wenn das Ventil (13, 14) geschlossen ist.

## Revendications

1. Un dispositif de réparation de masques comprenant une enceinte de réception de composé (12) à l'intérieur de laquelle se trouve un espace (2) destiné à emmagasiner un composé (1); et un élément de sortie de vapeur de composé (22) qui est disposé à l'intérieur d'une enceinte à vide (27) et qui est conçu pour communiquer avec l'espace (2) précité, caractérisé en ce que l'élément de sortie est constitué par une buse (22) qui est disposée dans une position immédiatement adjacente à l'espace (2) précité, et qui communique avec ce dernier par l'intermédiaire d'une valve (13, 14) de façon que pendant le fonctionnement, lorsque la valve (13, 14) est ouverte, de la vapeur du composé sorte de l'espace (2) précité et soit éjectée par la buse (22), sous la forme d'un jet.

2. Un dispositif de réparation de masques selon la revendication 1, caractérisé en ce que l'enceinte de réception de composé (12) est montée à l'intérieur de l'enceinte à vide (27).

3. Un dispositif de réparation de masques selon la revendication 1 ou 2, caractérisé en ce que la buse (22) communique avec l'espace précité (2) par l'intermédiaire d'un tube (3) qui est entouré par cet espace (2), la valve (13, 14) comprenant un siège de valve (13) sur une surface d'extrémité de ce tube (3), et un élément d'obturation (14) qui peut être déplacé de façon à être appliqué sur le siège de valve (13) et à être éloigné de ce dernier.

4. Un dispositif de réparation de masques selon l'une quelconque des revendications précédentes, caractérisé par des moyens de chauffage (23) destinés à chauffer le composé (1) qui se trouve dans l'espace précité (2).

5. Un dispositif de réparation de masques selon la revendication 4, caractérisé en ce que les moyens de chauffage (23) sont montés à l'extérieur de l'enceinte de réception de composé (12).

6. Un dispositif de réparation de masques selon l'une quelconque des revendications précédentes, caractérisé en ce qu'il comprend des moyens de déplacement (15) destinés à déplacer la buse (22) par rapport à un support d'échantillon (44), et des moyens de limitation (18, 42) pour limiter le mouvement de la buse (22) vers le support d'échantillon (44).

7. Un dispositif de réparation de masques selon la revendication 6, caractérisé en ce que la valve (13, 14) n'est ouverte que lorsque la buse (22) est dans une position prédéterminée par rapport au support d'échantillon (44).

8. Un dispositif de réparation de masques selon la revendication 6 ou 7, caractérisé en ce qu'il comprend des moyens destinés à déplacer le support d'échantillon (44) par rapport à la buse (22), ces moyens ne fonctionnant que lorsque la valve (13, 14) est fermée.

Fig. 1

Fig. 2

Fig. 3

Fig. 4

Fig. 5